# EUROPÄISCHE PATENTANMELDUNG

(11) **EP 0 748 047 A1**
(43) Veröffentlichungstag der Anmeldung: **11.12.1996**
(21) Anmeldenummer: 95105126.7
(22) Anmeldetag: 05.04.1995
(51) Int. Cl.: H03K 19/003, G05F 3/26

(54) **Integrierte Pufferschaltung**

(71) Anmelder: SIEMENS AKTIENGESELLSCHAFT, 80333 München (DE)
(72) Erfinder: Hoffmann, Kurt, Prof. Dr. Ing., D-82024 Taufkirchen (DE); Kowarik, Oskar, Dr., D-85579 Neubiberg (DE); Stecker, Johannes, Dr., D-80992 München (DE); Luther, Klaus, Dipl.-Ing., D-80337 München (DE)

(57) **Zusammenfassung**

Integrierte Pufferschaltung mit einem von der Versorgungsspannung unabhängigen Ausgangsstrom. Die Pufferschaltung weist eine zwischen einem ersten (VDD) und einem zweiten (Masse) Versorgungspotential angeordnete erste Serienschaltung (S1) mindestens einer spannungsgesteuerten ersten Konstantstromquelle (I1) und eines ersten Feldeffekttransistors (T1) auf, bei der das Gate des ersten Feldeffekttransistors (T1) den Eingang (IN) der Pufferschaltung bildet und ein Schaltungsknoten (A) der ersten Serienschaltung (S1) zwischen der ersten Konstantstromquelle (I1) und dem ersten Feldeffekttransistor (T1) den Ausgang (OUT) der Pufferschaltung bildet. Die erste Konstantstromquelle (I1) ist über einen ersten Steuereingang (G1) mit einem Referenzpotential (Vref) steuerbar, welches gegenüber dem ersten Versorgungspotential (VDD) eine konstante Potentialdifferenz aufweist. Es ist ferner eine zweite Serienschaltung (S2) aus mindestens einem ersten Widerstand (R1) und einer zweiten Konstantstromquelle (I2) zwischen dem ersten (VDD) und dem zweiten (Masse) Versorgungspotential vorgesehen. An einem Schaltungsknoten (A) der zweiten Serienschaltung (S2) zwischen dem ersten Widerstand (R1) und der zweiten Konstantstromquelle (I2) stellt sich das Referenzpotential (Vref) ein.

## Beschreibung

Die Erfindung betrifft eine integrierte Pufferschaltung nach dem Oberbegriff des Patentanspruchs 1.

Pufferschaltungen werden in integrierten Schaltkreisen häufig benötigt, beispielsweise um Eingangssignale der Schaltkreise an schaltkreisintern geforderte Signaleigenschaften (zum Beispiel Pegel) anzupassen oder um Ausgangssignale von Schaltungen an nachfolgende weitere Schaltungen anzupassen. Nachteilig bei Pufferschaltungen ist bekanntlich ihre Empfindlichkeit gegenüber Störungen (zum Beispiel Rauschen) auf den Leitungen für die Versorgungsspannung. Ihre Funktion ist weiterhin stark abhängig von bei der Versorgungsspannung eventuell auftretenden Spannungsschwankungen, dies insbesondere dann, wenn die Pufferschaltung Signale mit TTL-Pegel in solche mit CMOS-Pegeln umsetzen soll (TTL-Pegel: ≦0,8V und ≧2,4V; CMOS-Pegel: meist 0V und 4 bis 6V, typisch: 5V).

Im Zuge der fortschreitenden Miniaturisierung von integrierten Schaltungen kommen chipintern zunehmend niedrigere CMOS-Pegel zum Einsatz (zum Beispiel 0V und 3,3V). Oftmals ist es dabei erwünscht, den integrierten Schaltkreis wahlweise mit einer Versorgungsspannung für herkömmliche, höhere CMOS-Pegel oder mit einer niedrigeren Versorgungsspannung für niedrigere CMOS-Pegel zu betreiben.

Aus der EP-A 0 587 938 ist eine integrierte Pufferschaltung bekannt, welche eine spannungsgesteuerte Konstantstromquelle aufweist, die weitgehend unabhängig von Störungen auf den Leitungen für die Versorgungsspannung ist. Diese Konstantstromquelle wird über einen Steuereingang durch ein Referenzpotential gesteuert, welches gegenüber einem der Versorgungspotentiale eine konstante Potentialdifferenz aufweist. Die Konstantstromquelle ist aber nur bezüglich relativ kleiner Schwankungen der Versorgungsspannung von dieser unabhängig, da das Referenzpotential sonst nicht mehr dieselbe Potentialdifferenz gegenüber dem Versorgungspotential aufweist. Bei größeren Schwankungen der Versorgungsspannung um mehrere Volt beziehungsweise beim Betrieb der Schaltung mit unterschiedlich hohen Versorgungsspannungen (beispielsweise einmal für höhere CMOS-Pegel, ein andermal für niedrigere CMOS-Pegel) ist der von der Konstantstromquelle gelieferte Ausgangsstrom der Pufferschaltung nicht mehr konstant.

Ein konstanter Ausgangsstrom der Pufferschaltung ist jedoch erwünscht, um bei gleicher kapazitiver Last am Ausgang einen versorgungsspannungsunabhängigen Schaltpunkt und eine versorgungsspannungsunabhängige Schaltzeit der Pufferschaltung zu gewährleisten.

Der vorliegenden Erfindung liegt die Aufgabe zugrunde, eine integrierte Pufferschaltung zu finden, welche einen vom Versorgungspotential unabhängigen Ausgangsstrom liefert.

Diese Aufgabe wird durch eine gattungsgemäße Pufferschaltung mit den kennzeichnenden Merkmalen des Patentanspruchs 1 gelöst.

Die Erfindung beruht auf dem Prinzip, daß ein konstanter Strom durch einen linearen Widerstand einen konstanten Spannungsabfall über diesem verursacht. Liegt nun an einem Anschluß des Widerstandes ein veränderliches Versorgungspotential, erhält man am anderen Anschluß des Widerstandes ein Referenzpotential, welches gegenüber dem veränderlichen Versorgungspotential eine konstante Potentialdifferenz aufweist.

Vorteilhafte Aus- und Weiterbildungen der Erfindung sind in den Unteransprüchen gekennzeichnet.

Die Erfindung wird nachstehend anhand der Zeichnung näher erläutert. Es zeigen:
- Die Figuren 1 und 2: Ausführungsformen der Erfindung,
- die Figur 3: eine Schaltung zur Erzeugung eines Steuerpotentials für das Ausführungsbeispiel in Figur 2.

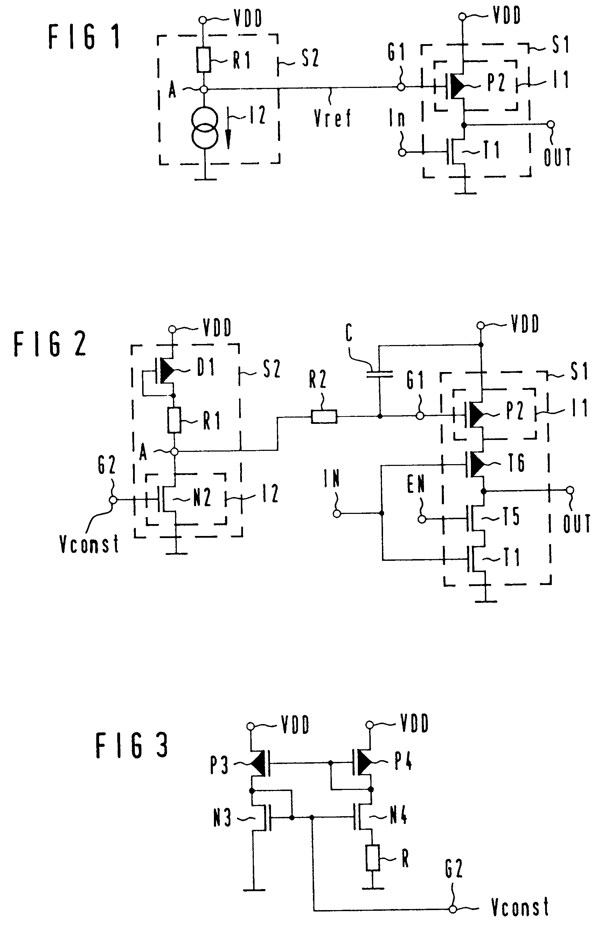

Als ein erstes Ausführungsbeispiel der Erfindung zeigt Figur 1 eine integrierte Pufferschaltung, welche in einer ersten Serienschaltung S1 einen ersten Feldeffekttransistor T1 vom n-Kanal-Typ und einen als eine erste Konstantstromquelle I1 fungierenden zweiten Feldeffekttransistor P2 vom p-Kanal-Typ aufweist. Die erste Serienschaltung S1 ist zwischen einem ersten Versorgungspotential VDD und einem zweiten Versorgungspotential Masse der Pufferschaltung angeordnet. Für die geschilderten Ausführungsbeispiele wird angenommen, daß das zweite Versorgungspotential Masse ein konstantes Bezugspotential ist und das zweite Versorgungspotential VDD Schwankungen unterworfen sein kann. Außerdem soll die Pufferschaltung mit ersten Versorgungspotentialen VDD unterschiedlicher Höhe betrieben werden können.

Weiterhin ist der zweite p-Kanal-Feldeffekttransistor P2 mit dem ersten Versorgungspotential VDD und der erste Feldeffekttransistor T1 mit dem zweiten Versorgungspotential Masse verbunden. Das Gate des ersten Feldeffekttransistors T1 bildet den Eingang IN der integrierten Pufferschaltung. Der Schaltungsknoten zwischen dem ersten Feldeffekttransistor T1 und dem zweiten p-Kanal-Feldeffekttransistor P2 bildet den Ausgang OUT der Pufferschaltung.

Ein erster Steuereingang G1 der ersten Konstantstromquelle I1 wird durch das Gate des zweiten p-Kanal-Feldeffekttransistors P2 gebildet. Der Strom, welcher von der ersten Konstantstromquelle I1 geliefert wird, soll unabhängig von Änderungen des ersten Versorgungspotentials VDD sein. Daher muß gewährleistet sein, daß die Gate-Source-Spannung des in Sättigung betriebenen zweiten p-Kanal-Feldeffekttransistors P2 auch bei Änderungen des ersten Versorgungspotentials VDD konstant bleibt. Ein an das Gate G1 des zweiten p-Kanal-Feldeffekttransistors P2 anzulegendes Referenzpotential Vref muß also auch bei Änderungen des mit der Source des zweiten p-Kanal-Feldeffekttransistors P2 verbundenen ersten Versorgungspotentials VDD gegenüber diesem eine konstante Potentialdifferenz aufweisen.

Erreicht wird dies, indem zwischen dem ersten Versorgungspotential VDD und dem zweiten Versorgungspotential Masse eine zweite Serienschaltung S2 angeordnet ist, welche einen ersten Widerstand R1 und eine zweite Konstantstromquelle I2 aufweist, wobei der erste Widerstand R1 mit dem ersten Versorgungspotential VDD und die zweite Konstantstromquelle I2 mit dem zweiten Versorgungspotential Masse verbunden ist. Zwischen dem ersten Widerstand R1 und der zweiten Konstantstromquelle I2 befindet sich ein Schaltungsknoten A der zweiten Serienschaltung S2. Dieser Schaltungsknoten A ist mit dem Gate G1 des zweiten p-Kanal-Feldeffekttransistors P2 verbunden. Am Schaltungsknoten A stellt sich das gewünschte Referenzpotential Vref ein.

Der erste Widerstand R1 kann beispielsweise ein ohmscher Widerstand oder ein als Widerstand verbundener Transistor sein.

Der von der zweiten Konstantstromquelle I2 erzeugte Strom durch die zweite Serienschaltung S2 ist unabhängig von Änderungen des ersten Versorgungspotentials VDD. Dieser konstante Strom verursacht am Widerstand R1 einen konstanten Spannungsabfall. Somit weist das Referenzpotential Vref gegenüber dem ersten Versorgungspotential VDD immer eine konstante Potentialdifferenz auf. Als Folge dessen erzeugt die erste Konstantstromquelle I1 sowohl bei Schwankungen des ersten Versorgungspotentials VDD als auch beim Betrieb mit einem niedrigeren oder einem höheren ersten Versorgungspotential VDD (beispielsweise 3,3 oder 5V) jederzeit einen Strom konstanter Stärke.

Figur 2 zeigt ein weiteres Ausführungsbeispiel der Erfindung, bei welchem die Pufferschaltung einen CMOS-Inverter aufweist. Der CMOS-Inverter beinhaltet den ersten Feldeffekttransistor T1 vom n-Kanal-Typ, dessen Source mit Masse verbunden ist. Seine Drain ist über einen fünften Feldeffekttransistor T5 vom n-Kanal-Typ mit einem sechsten Feldeffekttransistor T6 vom p-Kanal-Typ verbunden. Die Gates des ersten Feldeffekttransistors T1 und des sechsten Feldeffekttransistors T6 sind miteinander verbunden und bilden den Eingang IN der Pufferschaltung. Der Ausgang OUT der Pufferschaltung befindet sich an einem Schaltungsknoten der ersten Serienschaltung S1 zwischen dem fünften Feldeffekttransistor T5 und dem sechsten Feldeffekttransistor T6. Das Gate des fünften Feldeffekttransistors T5, welcher bei anderen Ausführungsformen der Erfindung auch entfallen kann, bildet einen Enable-Eingang EN der Pufferschaltung. Daneben ist auch die Anordnung weiterer Enable-Transistoren möglich. Mittels des Enable-Eingangs EN ist der CMOS-Inverter aktivierbar.

Auch bei dem Ausführungsbeispiel gemäß Figur 2 ist die erste Konstantstromquelle I1 durch den zweiten Feldeffekttransistor P2 vom p-Kanal-Typ realisiert. Sein Gate G1 ist über einen zweiten Widerstand R2 mit dem Schaltungsknoten A der zweiten Serienschaltung S2 verbunden. Außerdem ist das Gate G1 über einen Kondensator C mit dem ersten Versorgungspotential VDD verbunden. Der Kondensator C und der zweite Widerstand R2 dienen zur Dämpfung von Störungen der Versorgungspotentiale. Sie können auch entfallen.

Die zweite Serienschaltung S2 weist zusätzlich zu dem ersten Widerstand R1 und der mit diesem verbundenen zweiten Konstantstromquelle I2 einen als Diode D1 verbundenen p-Kanal-Feldeffekttransistor auf. Die Diode D1 ist zwischen dem ersten Versorgungspotential VDD und dem ersten Widerstand R1 angeordnet. Besonders vorteilhaft ist es, wenn die Diode D1 die gleichen elektrischen Eigenschaften wie der zweite p-Kanal-Feldeffekttransistor P2 der ersten Konstantstromquelle I1 aufweist. Dies führt zu einer Kompensation von Temperatureinflüssen und von Streuungen der Fertigungsparameter.

Die zweite Konstantstromquelle I2 ist bei diesem Ausführungsbeispiel durch einen zweiten n-Kanal-Feldeffekttransistor N2 realisiert, dessen Drain mit dem Schaltungsknoten A und dessen Source mit dem zweiten Versorgungspotential Masse verbunden ist. Die zweite Konstantstromquelle I2 ist spannungsgesteuert. Sie weist einen Steuereingang G2 auf, welcher durch das Gate des zweiten n-Kanal-Feldeffekttransistors N2 gebildet wird. Durch Anlegen eines gegenüber dem zweiten Versorgungspotential Masse eine konstante Potentialdifferenz aufweisenden Steuerpotentials Vconst fließt in der zweiten Serienschaltung S2 ein vom ersten Versorgungspotential unabhängiger, konstanter Strom.

Figur 3 zeigt einen Doppelstromspiegel, mit dessen Hilfe das konstante Steuerpotential Vconst zur Steuerung der zweiten Konstantstromquelle I2 des in Figur 2 dargestellten Ausführungsbeispiels erzeugbar ist. Der Doppelstromspiegel weist in einer Serienschaltung einen mit dem ersten Versorgungspotential VDD verbundenen dritten p-Kanal-Feldeffekttransistor P3 und einen mit dem zweiten Versorgungspotential Masse verbundenen dritten n-Kanal-Feldeffekttransistor N3 auf. Ferner weist der Doppelstromspiegel in einer Serienschaltung einen mit dem ersten Versorgungspotential VDD verbundenen vierten p-Kanal-Feldeffekttransistor P4, einen mit diesem verbundenen vierten n-Kanal-Feldeffekttransistor N4 sowie ein einerseits mit letzterem und andererseits mit dem zweiten Versorgungspotential Masse verbundenes Widerstandselement R auf.

Gate und Drain des dritten n-Kanal-Feldeffekttransistors N3 und des vierten p-Kanal-Feldeffekttransistors P4 sind jeweils miteinander verbunden. Die Gates des dritten P3 und vierten P4 p-Kanal-Feldeffekttransistors sind miteinander verbunden. Außerdem sind die Gates des dritten N3 und vierten N4 n-Kanal-Feldeffekttransistors miteinander verbunden. Letztere sind außerdem mit dem zweiten Steuereingang G2 der zweiten Konstantstromquelle I2 verbunden. An ihnen entsteht das Steuerpotential Vconst. Dieses ist unabhängig von Änderungen des ersten Versorgungspotentials VDD.

Betreibt man den Doppelstromspiegel im Unterschwelistrombereich (dies ist durch geeignete Dimensionierung erreichbar), so ist das Referenzpotential Vref unabhängig von technologisch bedingten Schwankungen des Widerstandswertes des Widerstandselementes R und des ersten Widerstandes R1.

Es ist auch möglich, das Steuerpotential Vconst nicht zwischen dem dritten N3 und dem vierten N4 n-Kanal-Feldeffekttransistor, sondern zwischen dem dritten P3 und dem vierten P4 p-Kanal-Feldeffekttransistor abzugreifen.

Zur Erzeugung des Steuerpotentials Vconst kann statt des Doppelstromspiegels aus Figur 3 beispielsweise auch eine andere Realisierung eines Doppelstromspiegels, ein einfacher Stromspiegel oder eine Bandgap-Reference eingesetzt werden.

Mit der erfindungsgemäßen integrierten Pufferschaltung sind weitgehend konstante Schaltzeiten erreichbar, auch wenn das erste Versorgungspotential VDD Werte zwischen 3V und 7V annimmt.

## Patentansprüche

1. Integrierte Pufferschaltung mit einem Eingang (IN) und einem Ausgang (OUT),
die eine zwischen einem ersten (VDD) und einem zweiten (Masse) Versorgungspotential angeordnete erste Serienschaltung (S1) mindestens einer spannungsgesteuerten ersten Konstantstromquelle (I1) und eines ersten Feldeffekttransistors (T1) aufweist,
wobei das Gate des ersten Feldeffekttransistors (T1) den Eingang (IN) bildet,
wobei die erste Serienschaltung (S1) einen Schaltungsknoten zwischen der ersten Konstantstromquelle (T1) und dem ersten Feldeffekttransistor (T1) aufweist, der den Ausgang (OUT) bildet
und wobei die erste Konstantstromquelle (I1) über einen ersten Steuereingang (G1) mit einem Referenzpotential (Vref) steuerbar ist, welches gegenüber dem ersten Versorgungspotential (VDD) eine konstante Potentialdifferenz aufweist,
**dadurch gekennzeichnet,**
daß eine zweite Serienschaltung (S2) aus mindestens einem ersten Widerstand (R1) und einer zweiten Konstantstromquelle (I2) zwischen dem ersten (VDD) und dem zweiten (Masse) Versorgungspotential angeordnet ist
daß sich an einem Schaltungsknoten (A) der zweiten Serienschaltung (S2) zwischen dem ersten Widerstand (R1) und der zweiten Konstantstromquelle (I2) das Referenzpotential (Vref) einstellt
und daß der Schaltungsknoten (A) mit dem ersten Steuereingang (G1) der ersten Konstantstromquelle (I1) verbunden ist.

2. Integrierte Pufferschaltung gemäß Anspruch 1,
**dadurch gekennzeichnet**,
daß die erste Konstantstromquelle (I1) einen zweiten Feldeffekttransistor eines ersten Kanal-Typs (P2) aufweist, dessen Gate der erste Steuereingang (G1) ist.

3. Integrierte Pufferschaltung gemäß Anspruch 2,
**dadurch gekennzeichnet**,
daß der erste Kanal-Typ ein p-Kanal-Typ ist
und daß die Source des zweiten Feldeffekttransistors vom ersten Kanal-Typ (P2) mit dem ersten Versorgungspotential (VDD) verbunden ist.

4. Integrierte Pufferschaltung gemäß einem der Ansprüche 2 oder 3,
**dadurch gekennzeichnet**,
daß das erste Versorgungspotential (VDD) über einen als Diode (D1) verbundenen Feldeffekttransistor mit denselben elektrischen Eigenschaften wie der zweite Feldeffekttransistor des ersten Kanal-Typs (P2) mit dem ersten Widerstand (R1) verbunden ist.

5. Integrierte Pufferschaltung gemäß einem der vorstehenden Ansprüche,
**dadurch gekennzeichnet**,
daß die zweite Konstantstromquelle (I2) über einen zweiten Steuereingang (G2) steuerbar ist und daß ein gegenüber dem zweiten Versorgungspotential (Masse) eine konstante Potentialdifferenz aufweisendes Steuerpotential (Vconst) mit dem zweiten Steuereingang (G2) verbunden ist.

6. Integrierte Pufferschaltung gemäß Anspruch 5,
**dadurch gekennzeichnet**,
daß die zweite Konstantstromquelle (I2) einen zweiten Feldeffekttransistor eines zweiten Kanal-Typs (N2) aufweist, dessen Gate der zweite Steuereingang (G2) ist.

7. Integrierte Pufferschaltung gemäß einem der Ansprüche 5 oder 6,
**dadurch gekennzeichnet**,
daß ein dritter Feldeffekttransistor des ersten Kanal-Typs (P3) und ein dritter Feldeffekttransistor des zweiten Kanal-Typs (N3) in Serie zwischen dem ersten (VDD) und dem zweiten (Masse) Versorgungspotential angeordnet sind,
daß ein vierter Feldeffekttransistor des ersten Kanal-Typs (P4), ein vierter Feldeffekttransistor des zweiten Kanal-Typs (N4) und ein Widerstandselement (R) in Serie zwischen dem ersten (VDD) und dem zweiten (Masse) Versorgungspotential angeordnet sind,
daß Gate und Drain des vierten Feldeffekttransistors des ersten Kanal-Typs (P4) miteinander verbunden sind,
daß Gate und Drain des dritten Feldeffekttransistors des zweiten Kanal-Typs (N3) miteinander verbunden sind,
daß die Gates des dritten (P3) und des vierten (P4) Feldeffekttransistors des ersten Kanal-Typs miteinander verbunden sind
und daß die Gates des dritten (N3) und des vierten (N4) Feldeffekttransistors des zweiten Kanal-Typs miteinander und mit dem zweiten Steuereingang (G2) der zweiten Konstantstromquelle (I2) verbunden sind.

8. Integrierte Pufferschaltung gemäß einem der Ansprüche 5 oder 6,
**dadurch gekennzeichnet**,
daß ein dritter Feldeffekttransistor des ersten Kanal-Typs (P3) und ein dritter Feldeffekttransistor des zweiten Kanal-Typs (N3) in Serie zwischen dem ersten (VDD) und dem zweiten (Masse) Versorgungspotential angeordnet sind,
daß ein vierter Feldeffekttransistor des ersten Kanal-Typs (P4), ein vierter Feldeffekttransistor des zweiten Kanal-Typs (N4) und ein Widerstandselement (R) in Serie zwischen dem ersten (VDD) und dem zweiten (Masse) Versorgungspotential angeordnet sind,
daß Gate und Drain des vierten Feldeffekttransistors des ersten Kanal-Typs (P4) miteinander verbunden sind,
daß Gate und Drain des dritten Feldeffekttransistors des zweiten Kanal-Typs (N3) miteinander verbunden sind,
daß die Gates des dritten (N3) und des vierten (N4) Feldeffekttransistors des zweiten Kanal-Typs miteinander verbunden sind
und daß die Gates des dritten (P3) und des vierten (P4) Feldeffekttransistors des ersten Kanal-Typs miteinander und mit dem zweiten Steuereingang (G2) der zweiten Konstantstromquelle (I2) verbunden sind.

9. Integrierte Puffeschaltung gemäß einem der vorstehenden Ansprüche,
**dadurch gekennzeichnet**,
daß der erste Widerstand (R1) ein als Widerstand verbundener Transistor ist.
